# EUROPEAN PATENT SPECIFICATION

(11) **EP 0 929 896 B1**
(45) Date of publication and mention of the grant of the patent: **28.11.2001**
(21) Application number: 97944574.9
(22) Date of filing: 29.09.1997
(51) Int. Cl.: G11C 7/00, G11C 17/12

(54) **MEMORY INCLUDING RESISTOR BIT-LINE LOADS**
SPEICHER MIT RESISTIVEN BITLEITUNGSBELASTUNGEN
MEMOIRE COMPRENANT DES CHARGES DE LIGNES DE BINAIRE RESISTIVES

(30) Priority: 30.09.1996 US 27329 P; 26.09.1997 US 937997
(43) Date of publication of application: 21.07.1999
(73) Proprietor: Advanced Micro Devices, Inc., Sunnyvale, CA 94088-3453 (US)
(72) Inventor: HOLST, John, Christian, San Jose, CA 95129 (US)
(74) Representative: Brookes Batchellor
(86) International application number: US9717559
(87) International publication number: WO9814947

(56) References cited:
- US-A- 4 096 522
- US-A- 4 270 190
- US-A- 4 802 128
- US-A- 5 255 235
- US-A- 5 517 061

## Description

The present invention relates to memories or storages for usage in circuits such as microprocessors. More specifically, the invention relates to read-only memory (ROM) structures using single-ended bit lines that are sensed differentially.

Microprocessor architectures are continually evolving to improve and extend the capabilities of personal computers. Circuit size, execution speed, and power consumption are aspects of microprocessors and microprocessor performance that are constantly addressed by processor architects and designers in the ongoing quest for an improved product. Reductions in circuit size are sought which do not compromise the performance or functionality of a microprocessor. For example, reductions in the circuit size of a read-only memory (ROM) are sought that do not reduce the storage capacity of the ROM. One technique for reducing circuit size in a microprocessor is to use single-ended bit lines in a ROM, rather than fully differential bit lines.

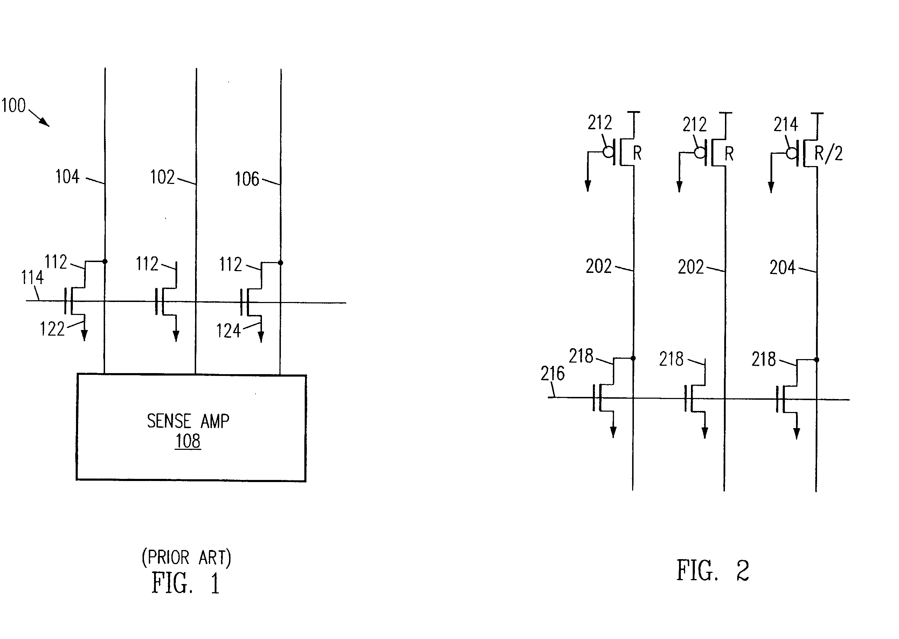

However, the sensing of single-ended bit lines in the presence of capacitive coupling from adjacent bit lines is a highly difficult task in the design of ROM structures. Referring to **FIGURE 1**, a schematic circuit diagram illustrates an example of a ROM structure. ROM memories typically include an array of memory cells **112,** connected among word lines **114** and bit lines **102, 104,** and **106.** In a ROM structure including single-ended bit lines, each memory cell **112** is connected to one word line and connected, if programmed, to one bit line. A memory cell can be programmed to discharge the bit line connected to the memory cell when the word line **114** connected to the cell is activated. The memory cells are either programmed by forming a transistor or not-programmed by not forming a transistor. In some cases, the transistor is always formed but the drain may or may not be connected to the bit line. A portion of a ROM memory **100** includes several bit lines, illustratively a middle "victim" bit line **102** and two bit lines **104** and **106** physically located adjacent to and on opposite sides of the victim bit line **102**. The victim bit line **102** is lightly loaded, having few memory cells that are programmed by forming a transistor and many memory cells in which transistors are not formed. Each programmed transistor contributes to the capacitance on a bit line. Non-programmed transistors do not substantially contribute to the capacitance. Therefore, bit lines with the fewest number of transistors have the lowest capacitance. In a worst case condition, bit lines **104** and **106** adjacent to the victim bit line **102** are also lightly loaded, causing the bit lines **104** and **106** to switch rapidly. Three sense amplifiers **108** (only one is shown), which are connected to the data bit lines **104** and **106** and the victim bit line **102**, differentiate between the analog voltage level that is produced when a memory cell transistor is programmed and the bit line thus discharged, and the analog voltage level produced when the memory cell transistor is not programmed and the bit line is not discharged.

A typical ROM bit line had between 256 and 1024 memory cells, although more memory cells are possible. Due to the large number of memory cells connected to a bit line, the signals that are carried by the bit line are generally slow moving signals. Therefore for high speed applications, advantages are gained by sensing small voltage differences on the bit lines and amplifying the small voltage differences to full logic levels, rather than driving the bit lines to swing by full logic levels. The minimum voltage swing for suitably transmitting signals on the bit lines is determined by two factors. A first factor is the sensitivity of a sense amplifier that is used to sense the bit line voltage. The amplifier sensitivity depends on the type of sense amplifier that is implemented. A coarse-sensing sense amplifier is an inverter and has a sensitivity equal to the trip point of the inverter, typically a significant fraction of the supply voltage. A fine-sensing sense amplifier is a good differential amplifier and has a sensitivity of about 50 mV.

A second factor determining the minimum voltage swing is the amount of coupling of other signals on the bit line. When the word line **114** is driven high, the adjacent data bit lines **104** and **106** each have actual transistors **122** and **124**, respectively, and are precharged to the high logic level (VDD) on the word line **114** and therefore will switch low, the bit lines **104** and **106** switch low. The victim bit line **102** does not have a transistor programmed to the word line **114** and therefore must remain high for the sense amplifier **108** to detect the correct logic state. Unfortunately, both the bit line **104** and the bit line **106** have a significant capacitance with respect to the victim bit line **102**, causing capacitive coupling between the victim bit line **102** and the adjacent data bit lines **104** and **106** to pull the victim bit line **102** down from an original high logic precharged level. The voltage of the victim bit line **102** sags even though no cell is programmed. To operate correctly, the sense amplifier **108** connected to the victim bit line **102** must discriminate between the voltage level resulting from the capacitive coupling to adjacent data bit lines **104** and **106** and the voltage level that results from a programmed transistor pulling the victim bit line **102** low. The sense amplifier **108** must detect that the bit lines that are programmed and therefore intended to be brought low are logic zeroes. The sense amplifier **108** is to detect that the victim bit line **102** that is gratuitously following the data bit lines **104** and **106** low is in fact a logic one.

One technique for handling capacitive coupling involves supplying a reference line at a voltage that is approximately midway between a top rail voltage and a low voltage. Capacitance is added to the reference line until a suitable discharge rate is found that is midway between the top rail voltage and the low voltage. Unfortunately, the addition of capacitance to the circuit has a cost in circuit area and results in structures that are not perfectly matched.

Another technique involves utilizing a reference line with a current set to half the current of a programmed memory cell using a current source or, for example, current mirrors. Unfortunately, the current mirrors easily come out of saturation and typically match poorly.

The usage of cascode sense amplifiers is another technique for sensing bit lines in the presence of capacitive coupling from adjacent bit lines. The use of a cascode device has several drawbacks. One disadvantage is that subthreshold leakage of the cascode device and an associated precharge device when memory cells are deactivated, for example due to operation in a stop clock mode, charges a bit line by some amount, such as about 100 mV. During operation of a ROM. a memory cell typically discharges the bit line by only a very small amount such as about 5 to 10 mV, an amount ten to twenty times smaller than the charge accumulated by leakage. Thus, the first access of a memory following the stop clock mode is delayed, possibly causing a memory access failure that is difficult to track due to dependence upon leakage current. In some cases, cumbersome circuitry is added to recognize and account for conditions arising from stop clock mode operation. In other cases, a circuit is added to generate a tail current to offset the leakage current, a solution that is very wasteful of operating power.

Another disadvantage of cascode devices is that cascode devices typically increase power supply requirements of the memory. A cascode device is a source-follower that requires more supply voltage than static gates so that a larger power supply is used and more power is dissipated. In many applications, such as portable computer applications, power supply restrictions limit the usefulness of cascode devices.

A further disadvantage of cascode devices is that the cascode device produces a "bootstrap" effect in which the victim line can reach a voltage sufficiently high that the cascode device is deactivated resulting in a longer access time in subsequent cycles the bit line is accessed.

What is needed is a memory circuit and technique for controlling signals in a memory that reduces capacitive coupling onto a single-ended bit line.

US4.270.190 describes a storage as indicated in the preamble of claim 1. Memory cell output signals are compared to a reference signal derived either from a dummy cell or from a memory cell being sensed; the reference signal and the memory cell signal are applied to a sense amplifier. US5,255,235 describes a dynamic RAM with dummy wordlines connected to bit line potential adjusting capacitors. Circuitry equalises differences between a first and second and third potentials; the first potential appears on a reference bit line paired with a bit line connected to a memory cell selected by an external address. US5,517,061 describes a CMOS ROM with programming at the second metal layer on a 2 metal process. US4,802,128 describes a bit line driver incorporating a pair of clamping MOS transistors connected separately to complimentary bit lines. US4,096,522 describes a monolithic semiconductor mask programmable ROM and a method for manufacturing the same.

It has been discovered that resistive bit line loads in a memory or storage are advantageously utilized to clamp the voltage swing of a bit line and reduce coupling from adjacent bit lines. The illustrative technique is applicable to storages including read-only memories (ROMs), static-RAM based register files, and many read and write ports.

In accordance with an embodiment of the present invention, a memory includes a data bit line and a reference bit line. Word lines in the memory are connected to the bit lines by transistors. The transistors on data bit lines and the reference bit lines are substantially the same size. The capacitances on the data bit lines are substantially the same as the capacitances on the reference bit lines. The reference bit lines however are distinguished from the data bit lines on the basis of resistance. Typically. the resistance of the reference bit line is set to be a fraction or a multiple of the resistance of the data bit lines. When the word line is activated, the bit lines express a steady-state voltage that is a function of the resistance of the bit lines. In one example, the data bit lines have a resistance R and the reference bit lines have half the resistance R/2. The same current is sourced to the data bit lines and the reference bit lines so that the steady-state voltage of the data bit line differs from the steady-state voltage of the reference bit line by a factor equal to the ratio of the resistances. Once adequate signal differentiation is effected, the sense amplifier in the ROM is strobed and the word line is reset.

The resistors R and R/2 perform two functions, the resistors clamp the level of the bit lines that are being discharged to stop the displacement current. When the displacement current stops, the resistors supply current to the victim bit line due to the voltage difference between the supply and the victim.

In accordance with an embodiment of the present invention, a storage includes a plurality of storage elements arranged in an array of rows and columns. a plurality of word lines connecting the array of storage elements into rows. and a plurality of resistively-loaded single-ended bit lines connecting the array of storage elements into columns. The single-ended bit lines include data bit lines and a reference bit line. The data bit lines are sensed differentially with respect to the reference bit line. The storage is characterised in that the plurality of resistibly-loaded single ended bit lines includes a plurality of data bit lines and a plurality of reference bit lines, a set reference bit line of the plurality of reference bit lines being allocated to a set of at least two data bit lines. the allocated set of data bit lines being sensed differentially with respect to the set reference bit line.

Many advantages are achieved by the described memory circuit and operating method. It is advantageous that the described memory circuit generates a differential signal which is compatible with regenerative sense amplifiers. It is advantageous that the described circuit and operating method do not require a two times capacitance on reference bit lines so that mismatches in bit line capacitance are tolerated. The disclosed memory circuit does not require a "half cell for the reference line. It is advantageous the described memory circuit attains the favorable increase in circuit density of a cascode circuit, while avoiding the serious drawbacks of the cascode solutions including a sensitivity to coupling and supply noise, limits on minimum VDD operation, static power dissipation, and a requirement for application of tail currents to prevent bit lines from charging during a stop clock operation.

The features of the described embodiments believed to be novel are specifically set forth in the appended claims. However, embodiments of the invention relating to both structure and method of operation, may best be understood by referring to the following description and accompanying drawings.

**FIGURE 1,** labeled PRIOR ART, is a schematic circuit diagram showing a portion of a ROM memory that includes several bit lines.

**FIGURE 2** is a schematic circuit diagram showing a reference bit line structure within the emulation code ROM shown in **FIGURES 6** and 7.

**FIGURES 3A** and **3B** are graphs that illustrate the effect of resistive bit-line loads.

**FIGURE 4** is a schematic block diagram illustrating a layout structure of the data bit lines and reference bit lines in an emulation code ROM.

**FIGURE 5** is an architectural block diagram which illustrates an embodiment of a microprocessor in accordance with an embodiment of the present invention.

**FIGURE 6** is a schematic block diagram showing an embodiment of an instruction decoder used in the processor shown in **FIGURE 5.**

**FIGURE 7** is a schematic block diagram which depicts a structure of an emulation code sequencer and an emulation code memory of the instruction decoder shown in **FIGURE 6.**

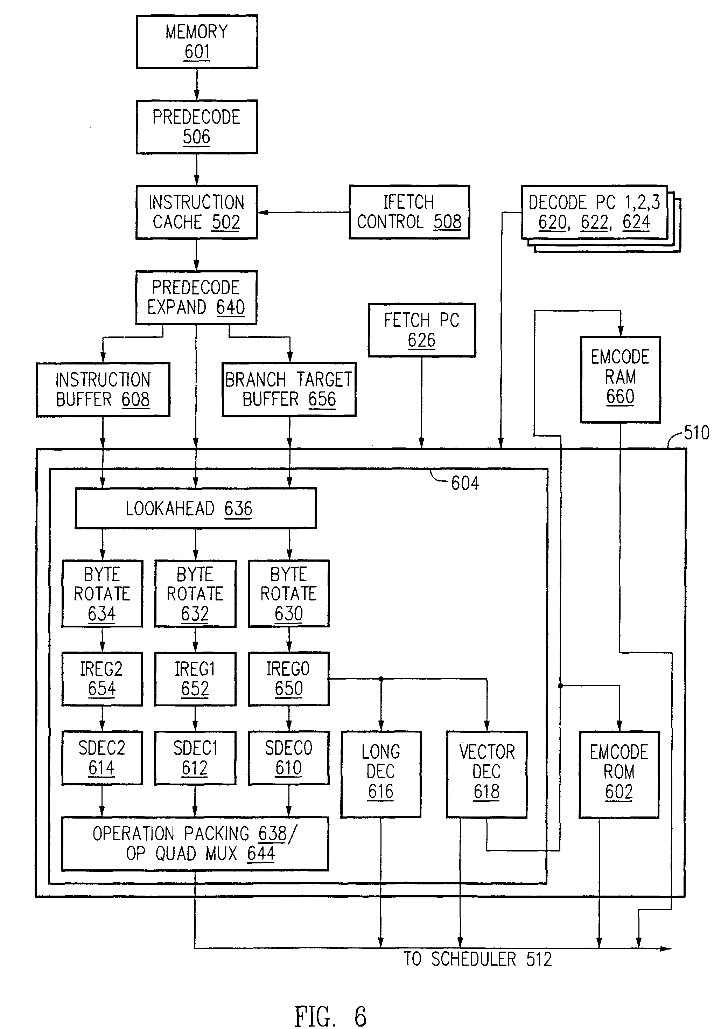

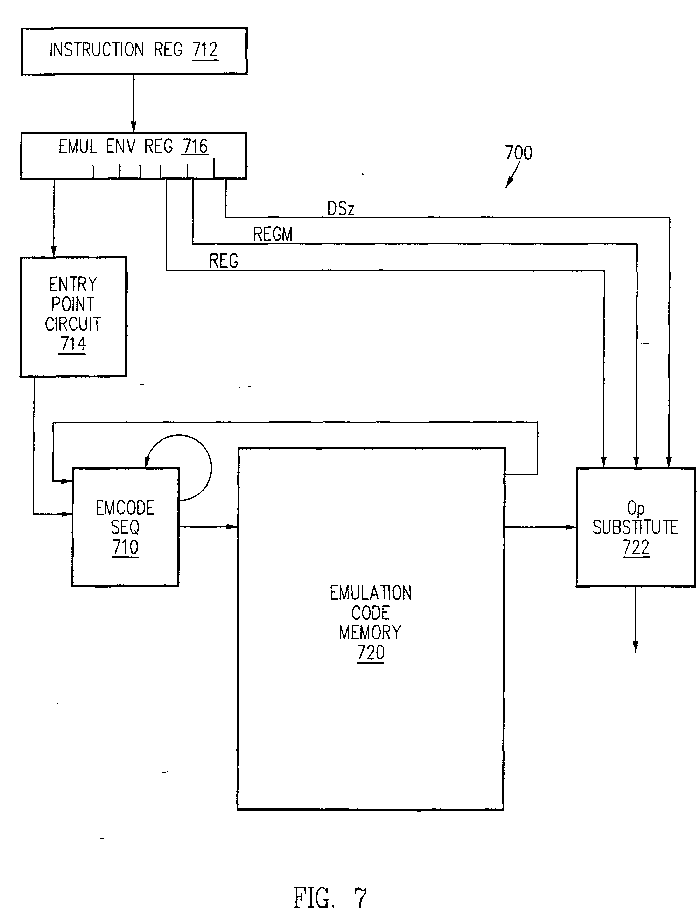

Referring to **FIGURE 2,** a schematic circuit diagram depicts a reference bit line structure within the emulation code ROM shown in **FIGURES 6** and **7**. The emulation code ROM **602** contains bit lines **202** that are single-ended but are sensed differentially with respect to a reference line **204.** The storage elements 218 are formed as transistors to attain a programmed state or the lack of a transistor to attain a nonprogrammed state. In the illustrative embodiment, the storage elements **218** are N-channel MOSFET transistors. The transistors and "nontransistors" have a drain terminal connected to the data bit lines **202** if programmed, a source terminal connected to a VSS reference, and a gate connected to a word line **216.** The reference line **204** is clamped using a resistive pull-up bit line load, including a grounded gate P-channel MOSFET resistor R/2 **214** that has a resistance half as large as the resistance of a grounded gate P-channel MOSFET resistor R **212** connected to the data bit lines **202** to constrain the voltage swing to half the voltage swing of the data bit lines **202.**

The storage elements **218** for the data bit lines **202** and the reference lines **204** are substantially the same size W. A steady-state signal only depends on the resistance R of the bit line pull-up transistor and the device size W. The capacitance on the data bit lines **202** and the reference lines **204** is also about equal. The capacitance determines the time duration elapsed in attaining the steady state signal. Amplitude differences between the signals on the data bit lines **202** and the reference lines **204** are based on differences in resistance. In the illustrative embodiment, the resistor **212** on the data bit lines **202** has a value R and the resistor **214** on the reference lines **204** has a value R/2. When the word line **216** is activated, the same current is applied to the data bit lines **202** and the reference lines **204** so that a steady-state voltage ΔV is measured on the data bit lines **202** and a steady-state voltage ΔV/2 is measured on the reference lines **204.**

The resistors R **212** and R/2 **214** are easily formed during layout of an integrated circuit by forming P-channel MOSFETs with grounded gates which operate in the linear region. In one embodiment, the resistors R **212** and R/2 **214** are fabricated using techniques that are similar to the fabrication of the storage elements **218** but are typically sized differently. For example, the resistors R **212** and R/2 **214** are typically two to four times larger than the storage elements **218,** advantageously a relatively small area in comparison to devices for precharging bit lines in memories using alternative sensing techniques. Generally a bit line only has a plurality of storage elements **218,** for example 256, but has only a single resistor. The resistors R **212** and R/2 **214** are advantageously formed at the edge of the ROM array of memory element transistors to form a compact structure. The resistors R **212** and R/2 **214** form a static load rather than a dynamic load, simplifying the memory structure and advantageously avoiding the need for precharge devices, drivers for driving the equilibrate-precharge devices, and timing circuits for timing of precharge operations. The resistors R **212** and R/2 **214** are sized to obtain a selected bit line excursion. For example, it is advantageous to clamp the entire voltage excursion to limit the displacement current through coupling capacitors. However, advantages are also gained by forming resistors R **212** and R/2 **214** that are sufficiently large to generate enough voltage swing to exceed the sensitivity level of the sense amplifier for sensing the bit line voltage.

In contrast to the emulation code ROM **602** that uses single-ended bit lines, other programmable elements in the microprocessor **500,** such as cells of programmable logic array (PLA) (not shown) within the floating-point unit (FPU) **526**, use fully differential bit lines. The emulation code ROM **602** employs single-ended bit lines **202** to reduce circuit area since a large amount of storage, in one embodiment 4k words by 169 bits, is consumed by the emulation ROM storage. The circuit area of the emulation code ROM **602** is reduced through usage of bit lines formed in a minimum-pitch metal 1 layer with no shielding. Shielding is conventionally used to avoid coupling. In the illustrative emulation code ROM **602**, coupling is reduced through usage of the resistive pull-up bit line load for the reference line **204** and the data bit lines **202**.

In one embodiment, the storage elements **218** are programmed in a metal layer (not shown). Programming in the metal layer advantageously allows a ROM to be programmed in a contact layer (not shown), subsequent to the formation of diffusion layers in silicon so that integrated circuits can be fabricated and store, but programmed later during contact masking. The emulation code ROM **602** is formed in a minimum pitch metal 1 layer with the bit lines formed in the metal 1 layer at very close to minimum spacing, for example a bit line width of 0.8 microns and spacing of 0.6 microns, to achieve a highly compact and dense ROM. The structure of the bit lines in the metal 1 layer results in a significant capacitance between the bit lines.

In an alternative embodiment, a circuit that is further reduced in size is attained using a diffusion-programmable ROM in which a transistor is programmed by forming a diffusion beneath a polysilicon layer (not shown) overlying a silicon wafer (not shown). A storage element with no diffusion is not a transistor and therefore not programmed. A diffusion-programmable ROM advantageously has a minimum size but is programmable only in the early fabrication stages.

In an illustrative embodiment, the emulation code ROM **602** is arranged as an array of storage elements with the individual storage elements including eight single-ended bit lines **202** that share a common reference line **204**. The individual single-ended bit lines **202** are accessed using 8:1 column decoding. The usage of the minimum-pitch metal 1 layer for the single-ended bit lines **202** without shielding is possible due to the use of resistive load elements for both bit lines **202** and reference lines **204**. The resistive pull-up bit line load is fabricated as a grounded gate P-channel MOSFET **212** which is biased in the linear region. The data bit line resistive pull-up bit line load **208** is fabricated to have twice the resistance of the reference line resistive pull-up bit line load. The difference in resistance to a reference voltage between the bit lines **202** and the reference lines **204** clamps the reference bit line **204** to swing to half the voltage that is spanned by the data bit lines **202.**

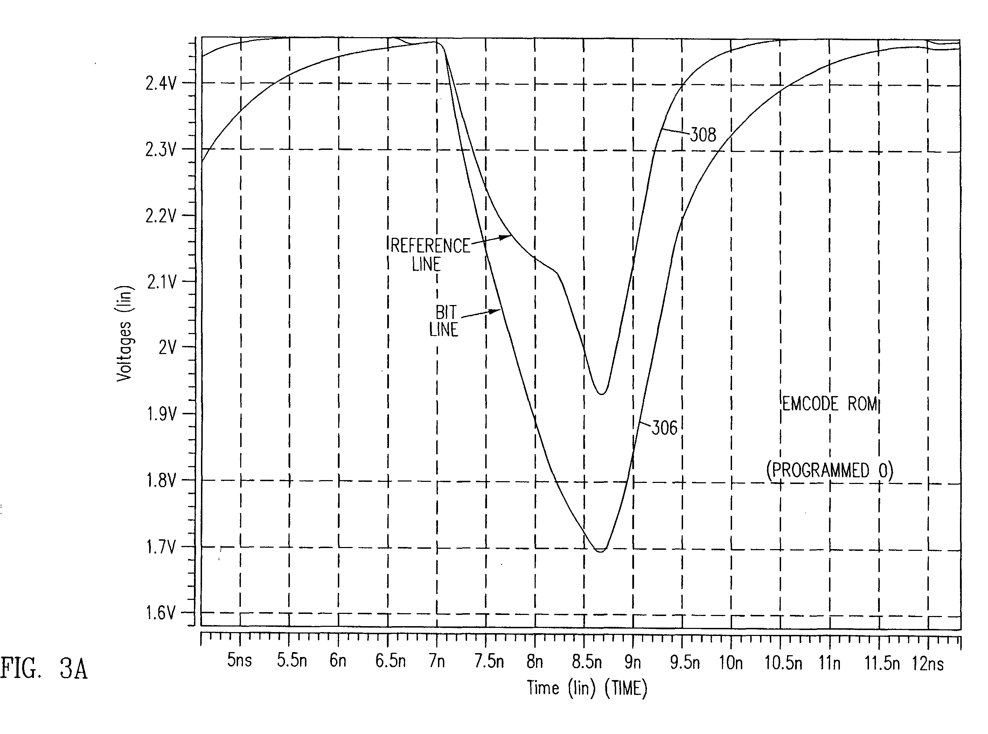

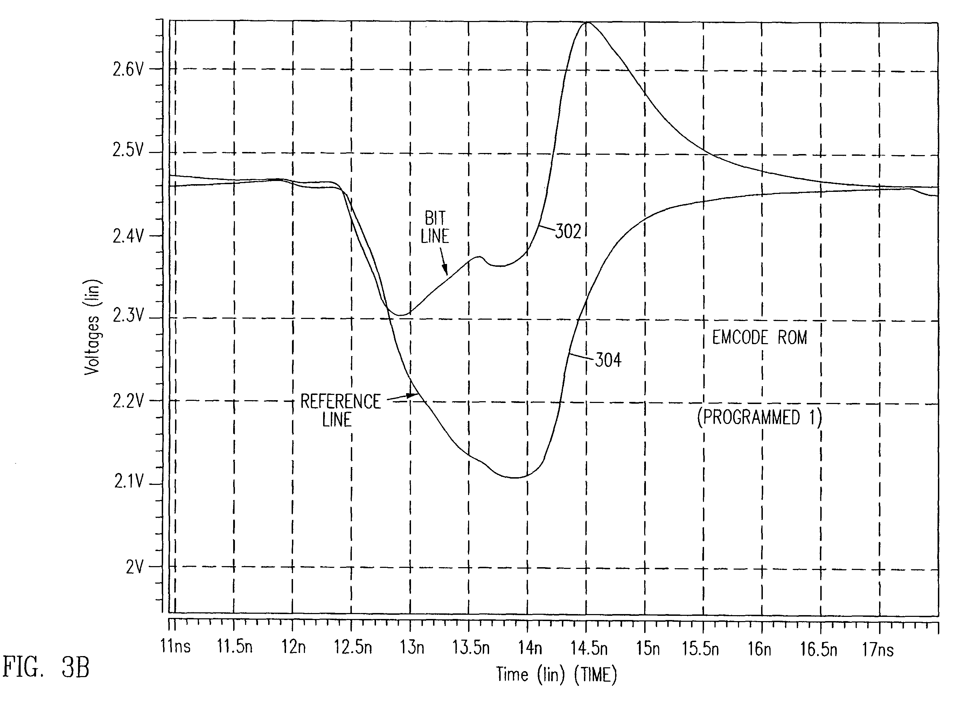

Since the voltage swing of the data bit line **202** is limited by the resistive clamp, the voltage signal that is coupled onto neighboring bit lines is reduced. **FIGURES 3A** and **3B** are graphic waveforms that illustrate In Circuit Emulator (SPICE) simulation waveforms showing the effect of resistive bit-line loads. The voltage on the data bit lines **202** is sensed when the word line **216** is activated. The data bit lines **202** are reduced in voltage by an amount ΔV while the voltage on the reference lines **204** is reduced by half that amount, ΔV/2. Once adequate signal differentiation occurs, a sense amplifier (not shown) is strobed and the word line **216** is reset generating a waveform shown in **FIGURE 3B.**

In **FIGURE 3B** a lightly loaded data bit line **302** is a "victim", a bit line that is not supposed to be discharged. The lightly loaded data bit line **302** is represented as a bit that is not driven down by a memory cell but, due to mutual capacitance between signals, is capacitively coupled down. The lightly loaded data bit line **302** is programmed to a "1" value or "unaccessed", is first coupled down by adjacent switching data bit lines, and is subsequently pulled back up by the resistive load before sensing occurs. The lightly loaded data bit line **302** is adjacent to two "accessed" data bit lines (not shown), which are programmed to a "0" value. The signal on the reference bit line **304** is also shown in **FIGURE 3B.** The data bit line **302** is first pulled down by the coupling, then pulled back up by the resistor, supplying a sensing margin when the sense amplifier fires. A small inflection **306** on the bit line signal **302** indicates firing of the sense amplifier. Following firing of the sense amplifier the word line is turned off and falls to the low level and the two accessed data bit lines couple into the data bit line signal **302** as the accessed data bit lines are pulled up, coupling the unaccessed bit line **302** even higher. The resistive bit line load quickly forces the data bit line to a proper equilibrium level before the next cycle begins.

**FIGURE 3A** shows that a heavily loaded bit line **306**, which is programmed to a "0" value, switches low compared to a reference line **308.** The simulated worst-case access time under typical conditions is 2.6 ns driving a 1.0pF output load.

The technique for reducing signal coupling in the emulation code ROM **602** using single-ended bit lines **202** that are sensed differentially with respect to a reference line **204** fundamentally differs from techniques employing fully differential bit lines. Fully differential bit lines use twisted bit lines to eliminate the effects of coupled. The single ended-bit lines **202** with resistive bit-line loads clamp the voltage level and uses the resistor to supply current to pull a victim line back up. Due to the resistive pull-up, the voltage excursion of the single bit line is limited to approximately 0.7V. The reduced voltage excursion reduces the amount of coupling onto an unaccessed bit line.

Several advantages are gained by the usage of resistive bit line loads to reduce coupling in comparison to other techniques that employ precharging and other methods. One advantage is that a reference line is shared among multiple data bit lines so that the size of the reference line is amortized over several bit lines. Another advantage is that all bit lines can be minimum pitch without requiring shield lines in between, also reducing the area consumed by the circuit. A further advantage is that 2x capacitances are not required on the reference lines **204,** increasing response speed. It is advantageous that mismatches in bit line capacitance are tolerated. Signal swing in the bit lines **202** is clamped so that the signal on a "victim" line between two adjacent bit lines recovers. The resistive load bit lines in combination with a reference line have nearly the same density as cascode solutions but advantageously avoids the traditional cascode drawbacks including sensitivity to coupling and supply noise. Furthermore, cascode methods limit the minimum VDD operation due to Vtn drop. Cascode circuits also often have static power dissipation and require tail currents to prevent bit lines from charging during power-down modes.

The illustrative reference bit line structure is highly suitable for implementation within the emulation code ROM and other ROM storages including, for example, a numerical processor ROM (not shown) or a ROM for storing three-dimensional display parameters.

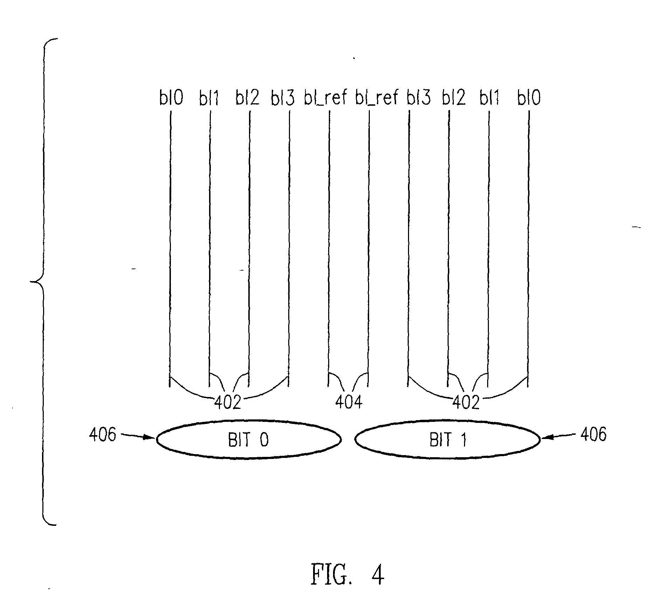

Referring to **FIGURE 4,** a schematic block diagram illustrates a layout structure of the data bit lines **402** and reference bit lines **404** in an emulation code ROM **602.** In the illustrative embodiment, the reference lines **404** and the data bit lines **402** are arranged so that reference lines **404** are adjacent. A column multiplexer **406** is connected to the bit lines so that input connections are programmable, allowing the bit line polarity of the emulation code ROM **602** to be inverted.

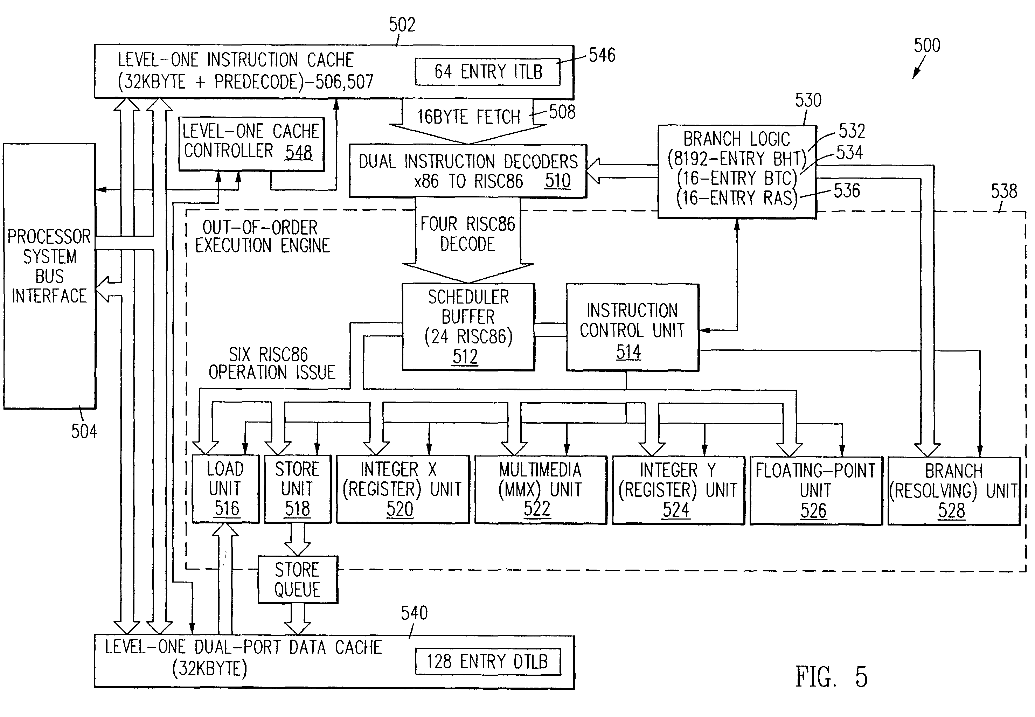

Referring to **Figure 5,** a schematic block diagram illustrates an embodiment of an AMD-K6 microprocessor **500.** The microprocessor **500** is an X86 instruction set-compatible microprocessor implementing a set of Multi-Media eXtenstions (MMX). A level-one (L1) instruction cache **502** begins predecoding instructions obtained from a processor system bus interface **504** during filling of the 32KB two-way associative L1 instruction cache **502.** The L1 instruction cache **502** includes a 64-entry instruction translational lookahead buffer (ITLB) **546.** Bypass (not shown) and storage buffers (not shown) for instructions (4x16) and predecode (4x20) to the L1 instruction cache **502** are supplied to allow data-in and data flow-back to cache output terminals.

A level-one cache controller **548** controls caching in the L1 instruction cache **502.** The L1 instruction cache **502** uses a Most Recently Used (MRU) prediction technique to predict the way selection on cache accesses. A misprediction in the way selection results in a penalty of one cycle. The L1 instruction cache **502** line replacement algorithm is Least Recently Used (LRU) although an alternative random replacement algorithm is supported using an SR5.ICERLR configuration bit. The L 1 instruction cache **502** also supports a direct-mapped replacement algorithm, reducing the cache size from 32KB to 16KB, using an SR5.ICDM configuration bit.

The L1 instruction cache **502** performs a simple prefetching algorithm. When a line miss occurs, as distinguished from a sub-block miss, and the miss occurs on sub-block 0 of the line (bit[5] of the address is 0), then both sub-blocks are fetched and pipelined on the bus.

The microprocessor **500** includes predecode logic **506** and a predecode cache **507** to identify instruction boundaries and fill the L1 instruction cache **502.** Once the L1 instruction cache **502** is filled, predecode bits are stored in the 20kB predecode cache **507.** Predecode bits resolved during the predecoding operation are stored in a 20KB predecode cache **507.** Predecode logic **506** includes a first stage of instruction decode logic. Data from the L1 instruction cache **502** are fetched by fetch logic **508** and transferred to dual instruction decoders **510.** The dual instruction decoders **510** decodes up to two X86 instructions per clock and translates most instructions through a direct hardware decode operation into from one to four RISC-like operations, called RISC86 Ops. The hardware-decoded instructions are generally simple and common-type instructions. Other complex or uncommon instructions are mapped into ROM-resident sequences of RISC Ops using emulation code ROM translation.

Decoded instructions from the dual instruction decoders **510** are transferred to a RISC86 Op Scheduler and buffer **512.** The RISC86 Op Scheduler **512** holds up to 24 RISC Ops and stores a total of 48 registers using register renaming. The Scheduler **512** contains logic to track instructions from decode to retirement, determining dependencies, scheduling execution, and committing architectural state. The Scheduler **512** is structured as a FIFO queue with instructions entering the queue four at one time to match the macroinstruction decoder bandwidth and up to four instructions retiring at one time at the end of the queue. Instructions enter the Scheduler **512** after decoding or fetching and remain in the scheduler queue until retirement. The Scheduler **512** queue is a general structure for usage for all categories of instructions and thus serves to hold instructions directed to different execution units. The Scheduler **512** utilizes implicit register renaming, which is based on position within the queue rather than explicit tag assignments, so that the Scheduler **512** avoids usage of full renaming hardware.

The Scheduler **512** manages creation and termination of operands using a hardware structure that is similar to a carry tree of a binary adder to improve speed performance, generating a carry bit for each operand while a most recent retiring or writing operation for a register terminates the carry bit. If a carry is made into a RISC86 Op and the destination of the RISC86 Op matches the operand, then that RISC86 Op is selected to supply the operand. The carry tree structure creates group generate Ggrp[7:0] and group propagate Pgrp[7:0] terms 3-RISC86 Op groups. The selection of 3-RISC86 Op groups is convenient since 24 RISC86 Ops are allocated in the Scheduler **512.** The eight group terms are combined in a three-level tree to create a group carry in terms Cgrp[7:0]. The group carry terms Cgrp[7:0] are used within each group to select the operand source Op.

The RISC86 Op Scheduler **512,** under control of an instruction control unit **514,** issues up to six RISC86 Operations using out-of-order issuing to seven parallel execution units. The execution units speculatively execute the RISC86 Ops to generate results. The RISC86 Op Scheduler **512** retires the results in-order. The execution units include a load unit **516,** a store unit **518,** an integer X register unit **520,** a Multi-Media eXtension (MMX) unit **522,** an integer Y register unit **524,** a floating-point unit (FPU) **526,** and a branch resolving unit **528.** A branch logic unit **530** implements a branch prediction operation that uses two-level branch prediction based on an 8192-entry Branch History Table (BHT) **532,** a 16-entry Branch Target Cache (BTC) **534,** and a 16-entry Return Address Stack (RAS) **536.**

The dual instruction decoders **510** translate X86 instructions on-the-fly into corresponding RISC86 Ops. The RISC86 Ops are executed by an instruction core **538** that is essentially a RISC superscalar processing engine. The fetch logic **508** fetches up to sixteen instruction bytes each cycle from the L1 instruction cache **502** and transfers the instruction bytes into an instruction buffer (not shown) preceding the dual instruction decoders **510** so that the instruction buffer is maintained at capacity. The dual instruction decoders **510** accesses the instruction bytes from the instruction buffer, decodes up to two X86 instructions, immediately recognizes and predicts branches, and generates up to four RISC86 Ops. The RISC86 Ops are loaded into the unified RISC86 Op Scheduler **512.** The RISC86 Op Scheduler **512** controls and tracks multiple aspects of RISC86 Op issue and execution.

The microprocessor **500** executes up to six operations per clock. Each cycle up to six RISC86 Ops are issued and executed in a pipelined manner. The six RISC86 Ops may include one memory read operation, one memory write operation, two integer and/or one multi-media register operation, one floating point operation, and one evaluation of a branch condition. The RISC86 Ops are executed out-of-order and are executed subject principally to actual dependencies and resource constraints. One example of a resource constraint is that a maximum of two integer register operations (RegOps) is executed per cycle. Once execution of the RISC86 Ops is complete, the RISC86 Op Scheduler **512,** functioning as a reorder buffer, commits the RISC86 Ops in-order to ensure precise exception handling and full operational compatability with X86 architecture standards. The RISC86 Op Scheduler **512** performs implicit register renaming based upon position within the scheduler buffer (queue) rather than explicit tag assignments that are conventionally employed in systems that use a reorder buffer. The position-based register renaming reduces the size of renaming hardware. The RISC86 Op Scheduler **512** has a first-in-first-out (FIFO) buffer physical structure and performs implicit register renaming, characteristics which, in combination, advantageously permit the use of fast position-based instruction issue and dependency-tracking logic. The dependency-tracking logic has characteristics of many fast adder circuits in which the process of searching for a particular operand is similar to the arithmetic operation of propagating a carry through an adder.

The load unit **516** loads data via a level-one (L1) dual-port data cache **540** which receives data from an external memory (not shown) via the processor system bus interface **504**. Bypass (not shown) and storage buffers (not shown) for data (4x16) to the data cache **540** are supplied to allow data-in and data flow-back to cache output terminals.

The data cache **540** includes a 128-entry data translational lookahead buffer (DTLB) **544.** The data cache **540** is a 2-way set-associative, 32KB size cache with a 64 byte line-size and 32-byte sub-blocking. The data cache **540** fills on the basis of the 32-byte sub-block units. In contrast to the L1 instruction cache **502,** the data cache **540** uses a Least Recently Missed (LRM) selection technique which is generally a more accurate way selection scheme than the LRU technique of the L1 instruction cache **502.** In the LRM scheme, the line that first enters the cache is replaced. An alternative random replacement algorithm is supported and activated through usage of a SR5.DCERLR configuration bit. The data cache **540** also supports a direct-mapped replacement algorithm, reducing the cache size from 32KB to 16KB, using an SR5.DCDM configuration bit.

The data cache **540** supports write allocation, which is disabled by setting an SR5.WAD configuration bit. Write allocation is allowed when caching is enabled through miscellaneous cache enable/disable bits and either of two conditions is true. A first condition is that a write operation hits on a line but misses on the requested sub-block. The second condition is that a write operation missed on a line but hit on a one-page cacheability control register used specifically on write-allocate operations. The cacheability control register is invalidated during RESET, translation lookahead buffer invalidations, or cache invalidations initiated by an INVD/WBINVD instruction. Snoop invalidations do not affect the cacheability control register. The cacheability control register is updated/validated on every fill with the page address of the line that was filled into the cache upon initiation by a load operation. Another cacheability control register is validated on write operations to the bus when the writes are determined to be cacheable.

The data cache **540** supports one read operation and one write operation on each cycle to either independent or dependent addresses. Stalls occur on cache misses or when a data dependency occurs that is not handled by hardware. For example, a stall takes place upon the occurrence of a read operation with a superset dependency on an older write operation that has not yet been cached. A superset dependency is defined as a read operation that requests more bytes than a write operation can supply. Address dependencies are detected by monitoring the number of requested bytes and a limited number of address bits (address bits [9:0]) due to timing constraints so that false dependencies may be detected, resulting in unnecessary stalls.

The store unit **518** transfers data to the data cache **540** through a store queue **542.**

The MMX unit **522** is implemented to incorporate an X86 instruction subset called the Multi-Media extensions (MMX) thereby supporting a growing number of applications in the areas of communications and multimedia. The MMX unit **522** supports the new instructions and the new data types that are defined by the MMX standard to increase processor performance in the targeted applications. The MMX unit **522** executes a Single Instruction, Multiple Data (SIMD) technique to process multiple operands of 8, 16, or 32 bits in a 64-bit data path to perform highly parallel and computationally intensive algorithms that are typical for multimedia applications. The MMX unit **522** supports 57 new instructions that execute additions, subtractions, multiplies, multiply-accumulates, logical shifts, arithmetic shifts, and several other operations. Most operations are executed on operands of any data type.

Referring to **FIGURE 6,** a schematic block diagram illustrates an embodiment an instruction path of the microprocessor **500** from a main memory **601** to the RISC86 Op RISC86 Op Scheduler **512.** The instruction path includes the L1 instruction cache **502** that is connected to the main memory **601** via the predecode logic **506.** The dual instruction decoders **510** is connected to receive instruction bytes and predecode bits from three alternative sources, the L1 instruction cache **502,** a branch target buffer (BTB) **656** and an instruction buffer **608.** The instruction bytes and predecode bits are supplied to the dual instruction decoders **510** through a plurality of rotators **630, 632** and **634** via instruction registers **650, 652** and **654.** The macroinstruction decoder **604** has input connections to the L1 instruction cache **502** and fetch logic **508** for receiving instruction bytes and associated predecode information. The macroinstruction decoder 604 buffers fetched instruction bytes in an instruction buffer **608** connected to the fetch logic **508.** The instruction buffer **608** is a sixteen byte buffer which receives and buffers up to 16 bytes or four aligned words from the L1 instruction cache **502,** loading as much data as allowed by the amount of free space in the instruction buffer **608.** The instruction buffer **608** holds the next instruction bytes to be decoded and continuously reloads with new instruction bytes as old ones are processed by the macroinstruction decoder **604.** Instructions in both the L1 instruction cache **502** and the instruction buffer **608** are held in "extended" bytes, containing both memory bits (8) and predecode bits (5), and are held in the same alignment. The predecode bits assist the macroinstruction decoder **604** to perform multiple instruction decodes within a single clock cycle.

Instruction bytes addressed using a decode program counter (PC) **620, 622,** or **624** are transferred from the instruction buffer **608** to the macroinstruction decoder **604.** The instruction buffer **608** is accessed on a byte basis by decoders in the macroinstruction decoder **604.** However on each decode cycle, the instruction buffer **608** is managed on a word basis for tracking which of the bytes in the instruction buffer **608** are valid and which are to be reloaded with new bytes from the L1 instruction cache **502.** The designation of whether an instruction byte is valid is maintained as the instruction byte is decoded. For an invalid instruction byte, decoder invalidation logic (not shown), which is connected to the macroinstruction decoder **604,** sets a "byte invalid" signal. Control of updating of the current fetch PC **626** is synchronized closely with the validity of instruction bytes in the instruction buffer **608** and the consumption of the instruction bytes by the dual instruction decoders **510.**

The macroinstruction decoder **604** receives up to sixteen bytes or four aligned words of instruction bytes fetched from the fetch logic **508** at the end of a fetch cycle. Instruction bytes from the L1 instruction cache **502** are loaded into a 16-byte instruction buffer **608.** The instruction buffer **608** buffers instruction bytes, plus predecode information associated with each of the instruction bytes, as the instruction bytes are fetched and/or decoded. The instruction buffer **608** receives as many instruction bytes as can be accommodated by the instruction buffer **608** free space, holds the next instruction bytes to be decoded and continually reloads with new instruction bytes as previous instruction bytes are transferred to individual decoders within the macroinstruction decoder **604.** The instruction predecode logic **506** adds predecode information bits to the instruction bytes as the instruction bytes are transferred to the L1 instruction cache **502.** Therefore, the instruction bytes stored and transferred by the L1 instruction cache **502** are called extended bytes. Each extended byte includes eight memory bits plus five predecode bits. The five predecode bits include three bits that encode instruction length, one D-bit that designates whether the instruction length is D-bit dependent, and a HasModRM bit that indicates whether an instruction code includes a modrm field. The thirteen bits are stored in the instruction buffer **608** and passed on to the macroinstruction decoder **604** decoders. The instruction buffer **608** expands each set of five predecode bits into six predecode bits.
Predecode bits enable the decoders to quickly perform multiple instruction decodes within one clock cycle.

The instruction buffer **608** receives instruction bytes from the L1 instruction cache **502** in the memory-aligned word basis of L1 instruction cache **502** storage so that instructions are loaded and replaced with word granularity. Thus, the instruction buffer **608** byte location 0 always holds bytes that are addressed in memory at an address of 0 (mod 16).

Instruction bytes are transferred from the instruction buffer **608** to the macroinstruction decoder **604** with byte granularity. During each decode cycle, the sixteen extended instruction bytes within the instruction buffer **608** , including associated implicit word valid bits, are transferred to the plurality of decoders within the macroinstruction decoder **604.** This method of transferring instruction bytes from the L1 instruction cache **502** to the macroinstruction decoder **604** via the instruction buffer **608** is repeated with each decode cycle as long as instructions are sequentially decoded. When a control transfer occurs, for example due to a taken branch operation, the instruction buffer **608** is flushed and the method is restarted.

The current decode PC has an arbitrary byte alignment in that the instruction buffer **608** has a capacity of sixteen bytes but is managed on a four-byte word basis in which all four bytes of a word are consumed before removal and replacement or the word with four new bytes in the instruction buffer **608.** An instruction has a length of one to eleven bytes and multiple bytes are decoded so that the alignment of an instruction in the instruction buffer **608** is arbitrary. As instruction bytes are transferred from the instruction buffer **608** to the macroinstruction decoder **604,** the instruction buffer **608** is reloaded from the L1 instruction cache **502.**

Instruction bytes are stored in the instruction buffer **608** with memory alignment rather than a sequential byte alignment that is suitable for application of consecutive instruction bytes to the macroinstruction decoder **604.** Therefore, a set of byte rotators **630, 632** and **634** are interposed between the instruction buffer **608** and each of the decoders of the macroinstruction decoder **604.** Four instruction decoders, including three short decoders SDec0 **610,** SDec1 **612** or SDec2 **614,** and one combined long and vectoring decoder **618,** share the byte rotators **630, 632** and **634.** In particular, the short decoder SDec0 **610** and the combined long and vectoring decoder **618** share byte rotator **630.** Short decoder SDec1 **612** is associated with byte rotator **632** and short decoder SDec2 **614** is associated with byte rotator **634.**

A plurality of pipeline registers, specifically instruction registers **650, 652** and **654,** are interposed between the byte rotators **630, 632** and **634** and the dual instruction decoders **510** to temporarily hold the instruction bytes, predecode bits and other information, thereby shortening the decode timing cycle. The other information held in the instruction registers **650, 652** and **654** includes various information for assisting instruction decoding, including prefix (e.g. 0F) status, immediate size (8-bit or 32-bit), displacement and long decodable length designations.

Although a circuit is shown utilizing three rotators and three short decoders, in other embodiments, different numbers of circuit elements may be employed. For example, one circuit includes two rotators and two short decoders.

Instructions are stored in memory alignment, not instruction alignment, in the L1 instruction cache **502,** the branch target buffer (BTB) **656** and the instruction buffer **608** so that the location of the first instruction byte is not known. The byte rotators **630**, **632** and **634** find the first byte of an instruction.

The macroinstruction decoder **604** also performs various instruction decode and exception decode operations, including validation of decode operations and selection between different types of decode operations. Functions performed during decode operations include prefix byte handling, support for vectoring to an emulation code ROM **602** for emulation of instructions, and for operations of the branch resolving unit **528,** branch resolving unit interfacing and return address prediction. Based on the instruction bytes and associated information, the macroinstruction decoder **604** generates operation information in groups of four operations corresponding to Op quads. The macroinstruction decoder **604** also generates instruction vectoring control information and emulation code control information. The macroinstruction decoder **604** also has output connections to the RISC86 Op Scheduler **512** and to the emulation ROM **602** for outputting the Op quad information, instruction vectoring control information and emulation code control information. In the illustrative embodiment, the emulation code ROM **602** contains 4k words by 169 bits of storage. The macroinstruction decoder **604** does not decode instructions when the RISC86 Op Scheduler **512** is unable to accept Op quads or is accepting Op quads from emulation code ROM **602.**

The macroinstruction decoder **604** has five distinct and separate decoders, including three "short" decoders SDec0 **610,** SDec1 **612** and SDec2 **614** that function in combination to decode up to three "short" decode operations of instructions that are defined within a subset of simple instructions of the x86 instruction set. Generally, a simple instruction is an instruction that translates to fewer than three operations. The short decoders SDec0 **610,** SDec1 **612** and SDec2 **614** each typically generate one or two operations, although zero operations are generated in certain cases such as prefix decodes. Accordingly for three short decode operations, from two to six operations are generated in one decode cycle. The two to six operations from the three short decoders are subsequently packed together by operation packing logic **638** into an Op quad since a maximum of four of the six operations are valid. Specifically, the three short decoders SDec0 **610,** SDec1 **612** and SDec2 **614** each attempt to decode two operations, potentially generating six operations. Only four operations may be produced at one time so that if more than four operations are produced, the operations from the short decoder SDec2 **614** are invalidated. The five decoders also include a single "long" decoder 616 and a single "vectoring" decoder **618.** The long decoder **616** decodes instructions or forms of instructions having a more complex address mode form so that more than two operations are generated and short decode handling is not available. The vectoring decoder **618** handles instructions that cannot be handled by operation of the short decoders SDec0 **610,** SDec1 **612** and SDec2 **614** or by the long decoder **616.** The vectoring decoder **618** does not actually decode an instruction, but rather vectors to a location of emulation ROM **602** for emulation of the instruction. Various exception conditions that are detected by the macroinstruction decoder **604** are also handled as a special form of vectoring decode operation. When activated, the long decoder **616** and the vectoring decoder **618** each generates a full Op quad. An Op quad generated by short decoders SDec0 **610,** SDec1 **612** and SDec2 **614** has the same format as an Op quad generated by the long and vectoring decoders **616** and **618.** The short decoder and long decoder Op quads do not include an OpSeq field. The macroinstruction decoder **604** selects either the Op quad generated by the short decoders **610, 612** and **614** or the Op quad generated by the long decoder **616** or vectoring decoder **618** as an Op quad result of the macroinstruction decoder **604** are each decode cycle. Short decoder operation, long decoder operation and vectoring decoder operation function in parallel and independently of one another, although the results of only one decoder are used at one time.

The vectoring decoder **618** handles instructions that are not decoded by either the short decoders or the long decoder **616.** Vectoring decodes are a default case when no short or long decoding is possible and sufficient valid bytes are available. Typically, the instructions handled by the vectoring decoder **618** are not included in the short decode or long decode subsets but also result from other conditions such as decoding being disabled or the detection of an exception condition. During normal operation, only non-short and non-long instructions are vectored. However, all instructions may be vectored. Undefined opcodes are always vectored. Only prefix bytes are always decoded. Prefix bytes are always decoded by the short decoders **610**, **612** and **614.**

When an instruction is vectored, control is transferred to an emulation code entry point. An emulation code entry point is either in internal emulation code ROM **602** or in an external emulation code RAM **660.** The emulation code starting from the entry point address either emulates an instruction or initiates appropriate exception processing.

A vectoring decode cycle is properly considered a macroinstruction decoder **604** decode cycle. In the case of a vectoring decode, the macroinstruction decoder **604** generate the vectoring quad and generate the emulation code address into the emulation code ROM **602.** Following the initial vectoring decode cycle, the macroinstruction decoder **604** remains inactive while instructions are generated by the emulation code ROM **602** or emulation code RAM **660** until a return from emulation (ERET) OpSeq is encountered. The return from emulation (ERET) sequencing action transitions back to macroinstruction decoder **604** decoding. During the decode cycles following the initial vectoring decode cycle, the macroinstruction decoder **604** remains inactive, continually attempting to decode the next "sequential" instruction but having decode cycles repeatedly invalidated until after the ERET is encountered, thus waiting by default to decode the next "sequential" instruction.

Instruction bytes for usage or decoding by the vectoring decoder **618** are supplied from the instruction buffer **608** by the first byte rotator **630,** the same instruction multiplexer that supplies instruction bytes to the first short decoder SDec0 **610** and to the long decoder **616.** The vectoring decoder **618** receives up to eleven consecutive instruction bytes, corresponding to the maximum length of a modr/m instruction excluding prefix bytes. Thus, the full eleven byte width of the first byte rotator **630** is distributed to both the long decoder **616** and the vectoring decoder **618.** The predecode information within the instruction buffer 608 is not used by the vectoring decoder **618.**

During a vectoring decode cycle, the vectoring decoder **618** generates a vectoring Op quad, generates an emulation code entry point or vector address, and initializes an emulation environment. The vectoring Op quad is specified to pass various information to initialize emulation environment scratch registers.

The value of the emulation code entry point or vector address is based on a decode of the first and second instruction bytes, for example the opcode and modr/m bytes, plus other information such as the presence of an OF prefix, a REP prefix or the like. In the case of vectoring caused by an exception condition, the entry point or vector address is based on a simple encoded exception identifier.

Referring to **FIGURE 7**, a schematic block diagram depicts an instruction decoder emulation circuit **700** including an instruction register **712,** an entry point circuit **714,** an emulation code sequencer **710,** an emulation code memory **720** and an Op substitution circuit **722.** The instruction decoder emulation circuit 700 is a circuit within the dual instruction decoders **510.** The instruction decoder emulation circuit **700** receives instruction bytes and associated predecode information from the instruction buffer **608** connected to the fetch logic **508,** the BTB **656** or the L1 instruction cache **502.** The instruction buffer **608** is connected to and supplies the instruction register **712** with x86 instructions. The instruction register **712** is connected to the entry point circuit **714** to supply emulation code ROM entry points. The entry point circuit **714** receives the x86 instruction and, from the x86 instruction operation code (opcode), generates an entry point address, a beginning address pointing into the emulation code memory **720.** In this manner an address of an instruction in emulation code memory **720** is synthesized from the opcode of an x86 instruction. The address is derived based on the x86 instruction byte, particularly the first and second bytes of the x86 instruction as well as information such as the modem byte, prefixes REP and REPE, the protected mode bit and effective data size bit DSz. Generally, closely related x86 instructions have similarly coded bit fields, for example a bit field indicative of instruction type is the same among related x86 instructions, so that a single entry in the emulation code memory **720** corresponds to several x86 instructions. Entry points are generally synthesized by reading the x86 instructions and assigning bits of the entry point address according to the values of particular x86 instruction bit fields. The instruction register **712** is connected to the emulation code sequencer **710** which, in turn, is connected to the emulation code memory **720.** The emulation code sequencer **710** applies the entry point to the emulation code memory **720** and receives sequencing information from the emulation code memory **720.** The emulation code sequencer **710** either controls the sequencing of instructions or, when a new sequence is to be started, applies an entry point to the emulation code memory **720.** Operations (Ops) encoded in the emulation code memory **720** are output by the emulation code memory **720** to the Op substitution circuit as Op quads or Op units. The Ops correspond to a template for RISC-type x86 operation. This template includes a plurality of fields into which codes are selectively substituted. The emulation code memory **720** is connected to the Op substitution circuit **722** to supply Ops into which the various Op fields are selectively substituted. Functionally, the entry point circuit **714** calculates an entry point into the emulation code ROM **602** or emulation code RAM **660.** The sequence in emulation code ROM **602** determines the functionality of an instruction.

The emulation code memory **720** includes an on-chip emulation code ROM **602** and an external emulation code RAM **660.** The emulation code memory **720** includes encoded operations that direct how the microprocessor **500** functions and defines how x86 instructions are executed. Both the emulation code ROM **602** and RAM **660** include a plurality of operation (Op) instruction encodings having a Op coding format that is the same in ROM **602** and RAM **660.** For example, in one embodiment the emulation code ROM **602** has a capacity of 4K 64-bit words.

The emulation code memory **720** supports a single-level (no nesting) subroutine functionality, in which an Opseq field is set to specify alternatives for fetching emulation code. The alternatives are structured as a typical two-way conditional branch, except that a 14-bit Op word address from the immediate field of a BRCOND Op within the Op quad or memory Op is loaded into a subroutine return address register. The subroutine return address register stores the 14-bit Op word address plus a single bit which designates whether the return address is located in emulation code ROM **602** or RAM **660.** The condition code specified by the BRCOND Op may be any alternative, including TRUE, so that both unconditional and conditional (predicted-taken) subroutines may be specified. However, the BRCOND Op must be specified to avoid loading an undefined value into the subroutine return address register.

All emulation code subroutine support and return address register management is performed by the emulation code sequencer **710** at the front of the pipeline. Thus return address register loading and usage is fully synchronous with standard decoder timing so that no delays are introduced.

While the invention has been described with reference to various embodiments, it will be understood that these embodiments are illustrative and that the scope of the invention is not limited to them. Many variations, modifications, additions and improvements of the embodiments described are possible. For example, those skilled in the art will readily implement the steps necessary to provide the structures and methods disclosed herein, and will understand that the process parameters, materials, and dimensions are given by way of example only and can be varied to achieve the desired structure as well as modifications which are within the scope of the invention. Variations and modifications of the embodiments disclosed herein may be made based on the description set forth herein, without departing from the scope and spirit of the invention as set forth in the following claims.

For example, the claims set forth a description of a storage or memory structure in which storage cells are arranged in rows and columns. This description is meant to convey the essence of any two-dimensional structure so that connections between rows and columns may be reversed.

In addition, although the described circuit and operating technique relates to an application of resistive bit-line loads in read-only memories (ROMs), the technique may also be applied in other storages including static RAM-based register files, and many read and write ports.

## Claims

1. A storage comprising:
a plurality of storage elements (218) arranged in an array of rows and columns;
a plurality of word lines (216) coupling the array of storage elements into rows; and
a plurality of resistively-loaded single-ended bit lines coupling the array of storage elements into columns, the single-ended bit lines including data bit lines (202, 402) and a reference bit line (204, 404). the data bit lines being sensed differentially with respect to the reference bit line.
**characterised in that** the plurality of resistively-loaded single-ended bit lines includes a plurality of data bit lines and a plurality of reference bit lines, a set reference bit line of the plurality of reference bit lines being allocated to a set of at least two data bit lines, the allocated set of data bit lines being sensed differentially with respect to the set reference bit line.

2. A storage as claimed in claim 1 which has a layout structure of the data bit lines (402) and reference bit lines (404) wherein the data bit lines are mirrored about their reference bit lines.

3. A storage according to claim 1 or 2. further comprising:
a column multiplexer (406) coupled to said set of at least two data bit lines all corresponding to the same bit of a single data word and coupled to the set reference bit line, the column multiplexer selecting from among the data bit lines for sensing a data bit line differentially with respect to the set reference bit line.

4. A storage according to any preceding claim, wherein:
the data bit lines and the reference bit line are resistively loaded using a resistive pull-up bit line load (212. 214).

5. A storage according to claim 4, wherein:
the data bit lines and the reference bit line are resistively loaded using a p-channel MOS resistive pull-up load.

6. A storage according to any one of claims 1 to 5, wherein:
the reference bit line is resistively loaded with a reference resistance (214);
the data bit lines are resistively loaded with a data bit line resistance (212); and
the reference resistance is a selected factor times the data bit line resistance.

7. A storage according to any one of claims 1 to 5, wherein:
the reference bit line is resistively loaded with a reference resistance (214);
the data bit lines are resistively loaded with a data bit line resistance (212); and
the reference resistance is approximately half the data bit line resistance.

8. A storage according to any preceding claim, wherein:
the storage elements are n-channel MOS transistors.

9. A storage according to any one of claims 1 to 7, wherein:
the storage elements are selectively programmed "on" transistors or programmed "off" transistors.

10. A storage according claim 9, wherein:
the storage elements are selectively programmed "on" transistors or programmed "off" transistors that are programmed in a metal 1 layer.

11. A storage according to any one of claims 1 to 7, wherein:
the storage elements are selectively programmed "on" transistors or programmed "off" transistors that are diffusion-programmed.

12. A storage according to any preceding claim, wherein:
the storage elements are read-only memory cells.

13. A processor (500) comprising:
an execution engine (538);
instruction decoder (510) coupled to the execution engine, the instruction decoder decoding instructions and supplying operations to the execution engine for execution;
a storage (602) as claimed in any preceding claim coupled to the instruction decoder, the storage supplying instructions to the instruction decoder for decoding into operations.

14. A storage according to any one of claims 1 to 7. wherein:
the storage elements are static RAM cells of a register file.

## Patentansprüche

1. Speicher mit:
- mehreren Speicherelementen (218), die als Anordnung von Reihen und Spalten angeordnet sind;
- mehreren Wortleitungen (216), welche die Anordnung von Speicherelementen zu Reihen verbinden; und
- mehreren mit Widerstandslast versehenen unsymmetrischen Bitleitungen, welche die Anordnung der Speicherelemente zu Spalten verbinden, wobei die unsymmetrischen Bitleitungen Datenbitleitungen (202, 402) und eine Referenzbitleitung (204, 404) aufweisen, wobei die Datenbitleitungen gegenüber der Referenzbitleitung differentiell abgetastet werden;
**dadurch gekennzeichnet, daß** die mehreren mit Widerstandslast versehenen unsymmetrischen Bitleitungen mehrere Datenbitleitungen und mehrere Referenzbitleitungen aufweisen, wobei eine Gruppen-Referenzbitieitung der mehreren Referenzbitleitungen einer Gruppe von wenigstens zwei Datenbitleitungen zugeordnet ist, wobei die zugeordnete Gruppe von Datenbitleitungen gegenüber der Gruppen-Referenzbitleitung differentiell abgetastet wird.

2. Speicher nach Anspruch 1, mit einer Layoutstruktur der Datenbitleitungen (402) und der Referenzbitleitungen (404), bei derdie Datenbitleitungen um ihre Referenzbitleitungen spiegelbildlich angeordnet sind.

3. Speicher nach Anspruch 1 oder 2, ferner mit:
- einem Spaltenmultiplexer (406), der mit der Gruppe der wenigstens zwei Datenbitleitungen, welche sämtlich demselben Bit eines einzelnen Datenworts entsprechen, und mit der Gruppen-Referenzbitleitung verbunden ist, wobei der Spaltenmultiplexer aus den Datenbitleitungen eine Datenbitleitung zum in bezug auf die Gruppen-Referenzbitleitung differentiellen Abtasten wählt.

4. Speicher nach einem der vorhergehenden Ansprüche, bei dem die Datenbitleitungen und die Referenzbitleitung unter Verwendung einer resistiven Pull-Up-Bitleitungslast (212, 214) mit einer Widerstandslast versehen sind.

5. Speicher nach Anspruch 4, bei dem die Datenbitleitungen und die Referenzbitleitung unter Verwendung einer resistiven p-Kanal-MOS-Pull-Up-Last mit einer Widerstandslast versehen sind.

6. Speicher nach einem der Ansprüche 1 bis 5, bei dem:
- die Referenzbitleitung mit einem Referenzwiderstand (214) belastet ist;
- die Datenbitleitungen mit einem Datenbitleitungswiderstand (212) belastet sind; und
- der Referenzwiderstand um einen ausgewählten Faktor höher ist als der Datenbitleitungswiderstand.

7. Speicher nach einem der Ansprüche 1 bis 5, bei dem:
- die Referenzbitleitung mit einem Referenzwiderstand (214) belastet ist;
- die Datenbitleitungen mit einem Datenbitleitungswiderstand (212) belastet sind; und
- der Referenzwiderstand ungefähr halb so groß ist wie der Datenbitleitungswiderstand.

8. Speicher nach einem der vorhergehenden Ansprüche, bei dem die Speicherelemente n-Kanal-MOS-Transistoren sind.

9. Speicher nach einem der Ansprüche 1 bis 7, bei dem die Speicherelemente selektiv als "eingeschaltete" Transistoren oder "ausgeschaltete" Transistoren programmiert sind.

10. Speicher nach Anspruch 9, bei dem die Speicherelemente selektiv als "eingeschaltete" Transistoren oder"ausgeschaltete" Transistoren programmiert sind, die in einer Metallschicht programmiert sind.

11. Speicher nach einem der Ansprüche 1 bis 7, bei dem die Speicherelemente selektiv als "eingeschaltete" Transistoren oder "ausgeschaltete" Transistoren programmiert sind, die diffusionsprogrammiert sind.

12. Speicher nach einem der vorhergehenden Ansprüche bei dem die Speicherelemente Nur-Lese-Speicherzellen sind.

13. Prozessor (500) mit:
- einer Ausführungsmaschine (538);
- einem Befehlsdecodierer (510), der mit der Ausführungsmaschine verbunden ist, wobei der Befehlsdecodierer Befehle decodiert und der Ausführungsmaschine Operationen zur Ausführung zuführt;
- einem mit dem Befehlsdecodierer verbundenen Speicher (602) nach einem der vorhergehenden Ansprüche, wobei der Speicher dem Befehlsdecodierer Befehle zum Decodieren zu Operationen zuführt.

14. Speicher nach einem der Ansprüche 1 bis 7, bei dem die Speicherelemente statische RAM-Zellen eines Registers sind.

## Revendications

1. Mémoire comprenant :
- une pluralité d'éléments de mémoire (218) disposés en une matrice de rangées et de colonnes ;
- une pluralité de lignes de mots (216) couplant la matrice d'éléments de mémoire en rangées ; et
- une pluralité de lignes de bits asymétriques et à charge résistive couplant la matrice d'éléments de mémoire en colonnes, les lignes de bits asymétriques comprenant des lignes de bits de données (202, 402) et une ligne de bits de référence (204, 404), les lignes de bits de données étant lues de façon différentielle par rapport à la ligne de bits de référence ;
- **caractérisée en ce que** la pluralité de lignes de bits asymétriques à charge résistive comprend une pluralité de lignes de bits de données et une pluralité de lignes de bits de référence, une ligne de bits de référence d'ensemble de la pluralité de lignes de bits de référence étant allouée à un ensemble d'au moins deux lignes de bits de données, l'ensemble alloué de lignes de bits de données étant lu de façon différentielle par rapport à la ligne de bits de référence d'ensemble.

2. Mémoire selon la revendication 1, qui possède une structure d'agencement des lignes de bits de données (402) et des lignes de bits de référence (404), dans laquelle les lignes de bits de données sont inversées par rapport à leurs lignes de bits de référence.

3. Mémoire selon la revendication 1 ou 2, comprenant en outre :
- un multiplexeur de colonnes (406) couplé audit ensemble d'au moins deux lignes de bits de données correspondant au même bit d'un mot de données unique et couplé à ladite ligne de bits de référence, le multiplexeur de colonnes effectuant une sélection parmi les lignes de bits de données pour lire une ligne de bits de données de façon différentielle par rapport à ladite ligne de bits de référence.

4. Mémoire selon une quelconque revendications précédentes, dans laquelle :
- les lignes de bits de données et la ligne de bits de référence sont chargées de façon résistive en utilisant une charge résistive d'excursion haute de ligne de bits (212, 214).

5. Mémoire selon la revendication 4, dans laquelle :
- les lignes de bits de données et la ligne de bits de référence sont chargées de façon résistive en utilisant une charge résistive d'excursion haute à transistor MOS canal p.

6. Mémoire selon une quelconque des revendications 1 à 5, dans laquelle :
- la ligne de bits de référence est chargée de façon résistive par une résistance de référence (214) ;
- les lignes de bits de données sont chargées de façon résistive par une résistance de ligne de bits de données (212) ; et
- la résistance de référence est égale à la résistance de lignes de bits de données multipliée par un facteur sélectionné.

7. Mémoire selon une quelconque des revendications 1 à 5, dans laquelle :
- la ligne de bits de référence est chargée de façon résistive par une résistance de référence (214) ;
- les lignes de bits de données sont chargées de façon résistive par une résistance de ligne de bits de données (212) ; et
- la résistance de référence est approximativement égale à la moitié de la résistance de ligne de bits de données.

8. Mémoire selon une quelconque revendication précédente, dans laquelle les éléments de mémoire sont des transistors MOS canal n.

9. Mémoire selon une quelconque des revendications 1 à 7, dans laquelle :
- les éléments de mémoire sont des transistors sélectivement programmés « conducteurs » ou « bloqués ».

10. Mémoire selon la revendication 9, dans laquelle :
- les éléments de mémoire sont des transistors sélectivement programmés « conducteurs » ou « bloqués » qui sont programmés dans une couche de métal 1.

11. Mémoire selon une quelconque des revendications 1 à 7, dans laquelle :
- les éléments de mémoire sont des transistors sélectivement programmés « conducteurs » ou « bloqués » qui sont programmés par diffusion.

12. Mémoire selon une quelconque des revendications précédentes, dans laquelle :
- les éléments de mémoire sont des cellules de mémoire à lecture seule.

13. Processeur (500) comprenant :
- un moteur d'exécution (538) ;
- un décodeur d'instructions (510) couplé au moteur d'exécution, le décodeur d'instructions décodant des instructions et délivrant des opérations destinées à être exécutées par le moteur d'exécution ;
- une mémoire (602) selon une quelconque des revendications précédentes, couplée au décodeur d'instructions, la mémoire délivrant des instructions au décodeur d'instructions afin de les décoder en opérations.

14. Mémoire selon une quelconque des revendications 1 à 7, dans laquelle :
- les éléments de mémoire sont des cellules de mémoire vive (RAM) d'un fichier de registre.
